# EUROPÄISCHE PATENTSCHRIFT

(11) **EP 1 932 407 B1**
(45) Veröffentlichungstag und Bekanntmachung des Hinweises auf die Patenterteilung: **21.09.2011**
(21) Anmeldenummer: 06775740.1
(22) Anmeldetag: 26.07.2006
(51) Int. Cl.: H05K 7/20, H01L 23/473

(54) **ELEKTRISCHES MODUL**
ELECTRICAL MODULE
MODULE ELECTRIQUE

(30) Priorität: 07.10.2005 DE 102005048492
(43) Veröffentlichungstag der Anmeldung: 18.06.2008
(73) Patentinhaber: Curamik Electronics GmbH, 92676 Eschenbach (DE)
(72) Erfinder: SCHULZ-HARDER, Jürgen, 91207 Lauf (DE); MEYER, Andreas, D-93173 Wenzenbach (DE)
(74) Vertreter: Graf, Helmut
(86) Internationale Anmeldenummer: PCT/DE2006/001284
(87) Internationale Veröffentlichungsnummer: WO 2007/041977

(56) Entgegenhaltungen:
- EP-A- 0 978 874
- EP-A1- 0 886 315
- WO-A-2005/067039
- US-A- 4 578 745

## Beschreibung

Die Erfindung bezieht sich auf ein elektrisches bzw. elektronisches Modul mit mehreren an einer gemeinsamen von einem Kühlmedium durchströmten Kühlerstruktur vorgesehenen elektrischen bzw. elektronischen Bauelementen oder Schaltkreisen.

Ein Modul der gattungsmäßigen Art ist bekannt (WO2005/067039 A1). Dieses bekannte Modul weist mehrere parallel zueinander angeordnete und voneinander beabstandete, von einem Kühlmedium durchströmbaren Kühler auf, die zum Zuführen und Abführen des Kühlmediums über balgartige Verbindungen miteinander sowie auch mit äußeren Kühlmediumanschlüssen verbunden sind. Zwischen den Kühlern sind integrierte elektrische Schaltkreise angeordnet, die jeweils in einem unter Verwendung einer Vergussmasse hergestellten flachen quaderförmigen Gehäuse Halbleiterbauelemente in Form von IGBTs und zugehörigen Dioden enthalten. Die Kühler stützten sich jeweils an der Ober- bzw. Unterseite der zwischen ihnen angeordneten Bauelemente ab und sind beispielsweise von einem Mehrkammerhohlprofil gebildet, welches mehrere parallel zueinander verlaufende und voneinander getrennte Kühlkanäle aufweist.

Bekannt sind weiterhin Kühler EP 0 978 874 A2, die mehrlagig aus einer Vielzahl von Lagen aus einem dünnen Metallblech besteht, von denen die inneren Lagen so strukturiert sind, dass sich in drei Raumachsen ständig verzweigende Strömungswege für das den Kühler durchströmende Kühlmedium ergibt und auch durchgehende Pfosten gebildet sind, die die Kühleroberseite mit der Kühlerunterseite verbinden. Ein Modulaufbau mit mehreren Kühlern und durch diesen angeordneten elektrischen Schaltkreisen ist nicht beschrieben.

Aufgabe der Erfindung ist es, ein Modul aufzuzeigen, welches bei vereinfachter Herstellung in einer sehr kompakten Bauform realisierbar ist. Zur Lösung dieser Aufgabe ist ein Modul entsprechend dem Patentanspruch 1 ausgebildet.

Bei der Erfindung ist das elektrische Modul so ausgebildet, dass die gemeinsame Kühlerstruktur aus wenigstens zwei plattenförmigen parallel zu einander und im Abstand voneinander angeordneten, von dem Kühlmedium durchströmten Kühlern besteht, dass zumindest ein Schaltkreis auf einem Kühler in einem Raum zwischen zwei benachbarten Kühlern vorgesehen ist, dass jeder Kühler aus mehreren miteinander verbundenen Lagen aus Metallblech oder - folie besteht, dass innere Lagen jedes Kühlers durch in diese Lagen eingebrachte Öffnungen derart strukturiert sind, dass sich ein innerer, strukturierter Kühlbereich ergibt, der einen sich in allen drei Raumachsen ständig verzweigenden Strömungsweg für das Kühlmedium bildet, und dass die miteinander verbundenen Lagen im strukturierten Bereich durchgehende Pfosten bilden, die sich bis an die Ober- und Unterseite bzw. bis an die die Ober- und Unterseite des betreffenden Kühlers bildenden Lagen erstrecken.

Dies hat u.a. den Vorteil, dass durch die spezielle Ausführung des Kühlers (bestehend aus mehreren miteinander verbundenen Lagen aus Metallfolien mit einem von der Strukturierung der inneren Lagen gebildeten, sich ständig verzweigenden Strömungsweg) eine hohe Kühlleistung mit dem den Kühler durchströmenden Kühlmedium erreicht wird. Durch die von der Strukturierung der inneren Lagen gebildeten Pfosten, die sich zwischen der Ober- und Unterseite des jeweiligen Kühlers erstrecken ist weiterhin eine hohe Stabilität für die einzelnen Kühler erreicht, insbesondere auch dahingehend, dass sich diese bei einem Druck des Kühlmediums nicht "aufblähen". Hierdurch ist ohne die Gefahr von unerwünschten Berührungen oder elektrischen Kontakten vermieden, so dass aufgrund der Hohen Kühlleistung und der hohen Stabilität der Kühler eine sehr kompakte Bauform des Moduls bei dicht übereinander angeordneten Kühlern möglich ist.

In Weiterbildung der Erfindung ist das Modul beispielsweise so ausgebildet,
dass die Anzahl der parallel zueinander und im Abstand voneinander angeordneten Kühler größer als Zwei ist,
und/oder
dass zumindest ein Kühler der Kühleranordnung an zwei einander gegenüberliegenden Seiten jeweils wenigstens ein zu kühlendes Bauelement aufweist,
und/oder
dass die Dicke der Kühler um ein Vielfaches kleiner ist als deren Abmessung in Draufsicht, beispielsweise Breite und/oder Länge,
und/oder
dass die Bauelemente jeweils Teil eines elektrischen oder elektronischen Schaltkreises sind,
und/oder
dass wenigstens ein erster Kanal zum Zuführen und Verteilen des Kühlmediums an die Kühler sowie wenigstens ein zweiter Kanal zum Abführen des Kühlmediums von den Kühlern vorgesehen ist,
und/oder
dass die Kühler parallel zueinander in einem Kühlmediumkreislauf angeordnet sind, und/oder
dass Anschlüsse zum Anschließen des Moduls an einen Kühlmediumkreislauf vorgesehen sind,
und/oder
dass die Anschlüsse an einer gemeinsamen Seite des Moduls vorgesehen sind, und/oder
dass die Kühler durch Abstandhalter und/oder Abschlussstücke voneinander und/oder von das Modul zusammenhaltenden Spannelementen, beispielsweise Spannplatten beabstandet sind,
und/oder
dass die Abstandhalter oder Abschlussstücke aus einem elektrisch isolierenden Material, beispielsweise aus Kunststoff gefertigt sind,
und/oder
dass die Abstandhalter und/oder Abschlussstücke quader- oder plattenförmig ausgeführt sind,
und/oder
dass der wenigstens eine erste Kanal und/oder der wenigstens eine zweite Kanal teilweise in den Abstandhaltern ausgebildet ist,
und/oder
dass die Abstandhalter und/oder Abschlussstücke Einzelelemente sind, und/oder
dass die Abstandhalter und/oder Abschlussstücke zumindest teilweise von einem gemeinsamen Abstandhalterelement gebildet sind,
und/oder
dass an zwei einander gegenüberliegenden Seiten des Moduls jeweils mehrere Abstandhalter vorgesehen sind, und dass die Abstandhalter an jeder Seite des Moduls von wenigstens einem Abstandhalterelement gebildet sind,
und/oder
dass das wenigstens eine Bauelement und/oder der wenigstens eine Schaltkreis zwischen dem wenigstens einen ersten Kanal und dem wenigstens einen zweiten Kanal vorgesehen ist,
und/oder
dass das wenigstens eine elektrische Bauelement und/oder der wenigstens eine elektrische Schaltkreis zwischen zwei Abstandhaltern vorgesehen ist,
und/oder
dass elektrische Anschlusselemente zum Anschließen des Moduls an äußere Verbindungen an wenigstens einer gemeinsamen Seite des Moduls vorgesehen sind,
und/oder
dass die Kühler jeweils eine innere, mit dem Kühlmedium unmittelbar in Berührung stehende Kühlfläche sowie eine äußere, mit dem wenigstens einem Bauelement oder dem wenigstens einen Schaltkreis in Verbindung stehende Kühlfläche bilden, und dass die innere Kühlfläche größer ist als die äußere Kühlfläche,
und/oder
dass die innere Kühlfläche wenigstens um den Faktor drei größer ist als die äußere Kühlfläche,
und/oder
dass jeder Kühler eine Kühlleistung von wenigstens 25 W/cm² aufweist, und zwar bezogen auf die von dem wenigstens einen zu kühlenden Bauelement (3, 4, 5) oder dem wenigstens einen zu kühlenden Substrat eingenommene Kühleraußenfläche,
und/oder
dass der wenigstens eine Schaltkreis ein Substrat aufweist, welches eine Schicht aus einem elektrisch isolierenden Material, beispielsweise eine Keramikschicht und an einer Oberflächenseite dieser Schicht wenigstens eine strukturierte Metallisierung aufweist,
und/oder
dass das Substrat auch an der anderen Oberflächenseite der Isolierschicht mit einer Metallisierung versehen ist, die ihrerseits mit dem Kühler verbunden ist,
und/oder
dass das Substrat unter Anwendung des Direct-Bonding-Verfahrens (DCB-Verfahren) hergestellt und/oder mit dem jeweiligen Kühler verbunden ist,
und/oder
dass das Substrat unter Verwendung des Aktivlöt-Verfahrens hergestellt und/oder mit dem jeweiligen Kühler verbunden ist,
wobei die vorstehenden Merkmale jeweils einzeln oder in beliebiger Kombination verwendet sein können.

Weiterbildungen der Erfindung sind Gegenstand der Unteransprüche. Die Erfindung wir im Folgenden anhand der Figuren an Ausführungsbeispielen näher erläulert. Es zeigen:
- Fig. 1: in vereinfachter Darstellung und im Schnitt ein aktiv gekühltes Modul gemäß der Erfindung;
- Fig. 2: eine Draufsicht auf das Modul der Figur 1;
- Fig. 3: in perspektivischer Darstellung einen Abstandhalter zur Verwendung bei dem Modul in der Figur 1;
- Fig. 4 u. 5: jeweils in Teildarstellung zwei innere Lagen eines Kühlers zur Verwendung bei dem Modul der Figuren 1 und 2;
- Fig. 6 u. 7: in Teildarstellung eine Schichtfolge im Bereich eines Schaltkreises bei unterschiedlichen Ausführungen;
- Fig. 8: in Teildarstellung ein Abstandhalter- und Anschlusselement zur Verwendung bei einem Modul gemäß der Erfindung;
- Fig. 9: eine Darstellung ähnlich Figur 2 bei einer weiteren möglichen Ausführungsform.

In den Figuren ist 1 ein elektrisches oder elektronisches Modul, welches u. a. aus mehreren, d. h. bei der dargestellten Ausführungsform aus insgesamt drei parallel übereinander angeordneten und voneinander beabstandeten plattenförmigen Kühlern 2 steht, die bei der dargestellten Ausführungsform jeweils an der Oberseite mit einem mehrere elektrische Bauelemente, beispielsweise Bauelemente 3, 4 und 5 aufweisenden elektronischen Schaltkreis 6 versehen sind.

Zumindest eines dieser Bauelemente, beispielsweise das Bauelement 5 ist ein Leistungsbauelement, beispielsweise ein elektrischer Widerstand, eine Diode, ein Transistor, ein IGB, ein Tyristor, Triac usw., welches während des Betriebes eine nicht unerhebliche Verlustleistung erzeugt und aus diesem Grunde mit dem zugehörigen Kühler 2 gekühlt werden muss. In der praktischen Ausführung sind die Bauelemente 3 - 5 jedes Schaltkreises 6 in einem geschlossenen Gehäuse 6.1 untergebracht, d. h, z. B. mit Kunststoff vergossen.

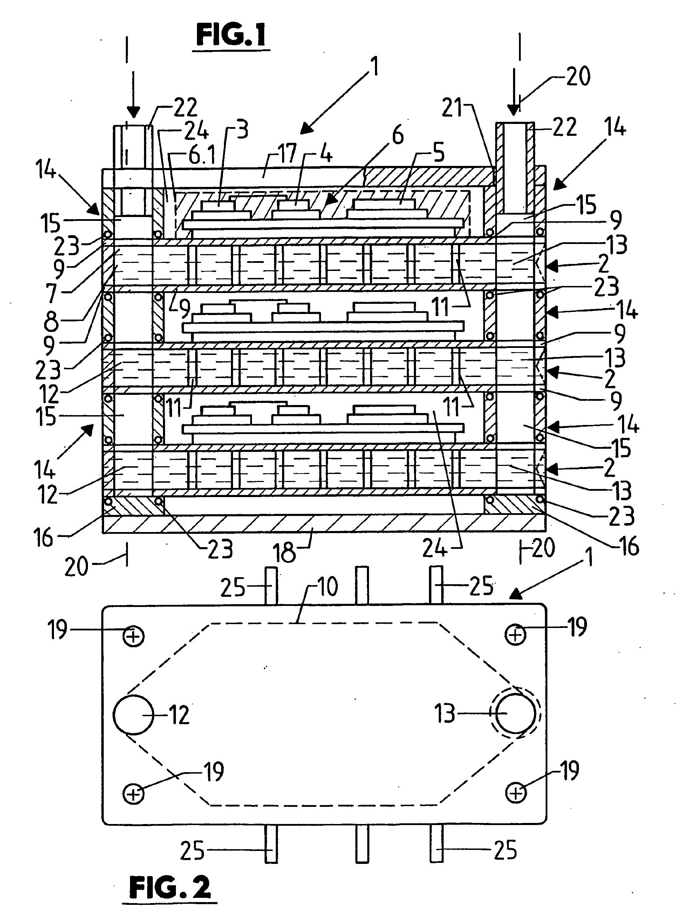

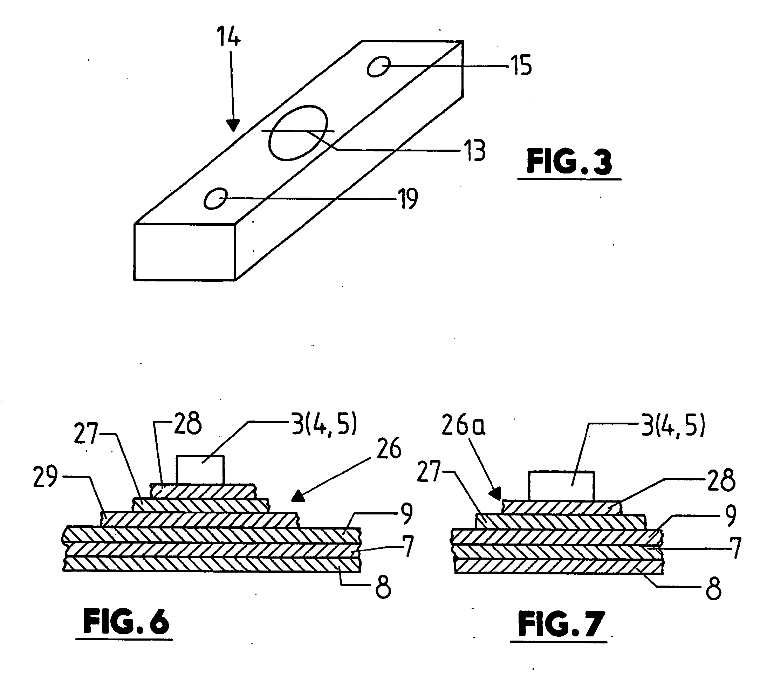

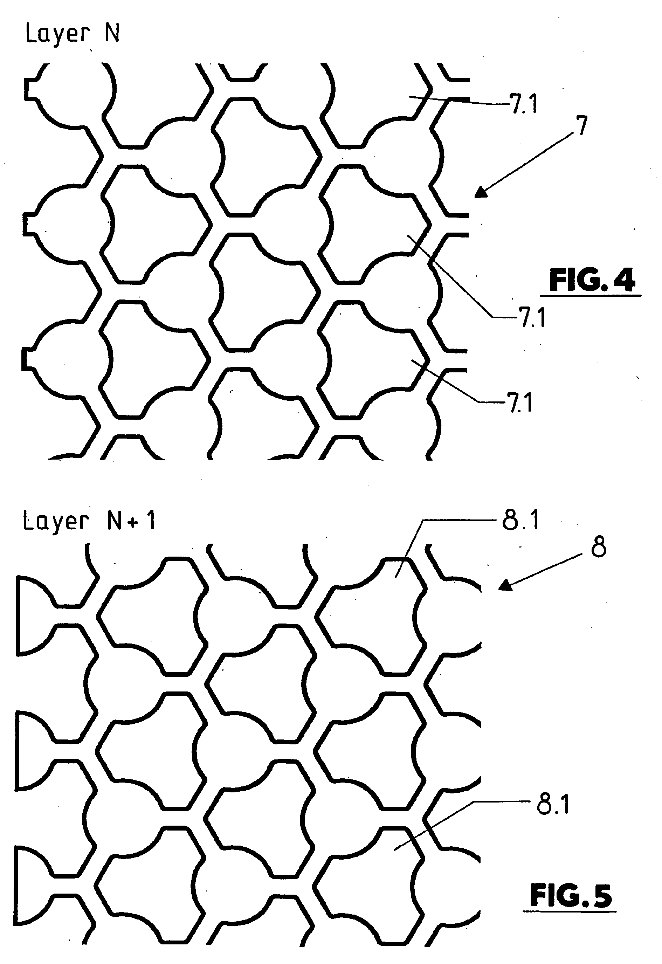

Die Kühler 2 sind jeweils mehrlagig aus dünnen Metallschichten oder -blechen eines geeigneten, Wärme gut transportierenden Materials, beispielsweise aus Kupfer hergestellt, und zwar aus inneren Schichten 7 und 8 sowie aus äußeren Schichten 9. Die inneren Schichten 7 und 8 sind in der in den Figuren 3 und 4 dargestellten Weise strukturiert bzw. mit einer Vielzahl von Öffnungen versehen, und zwar derart, dass sich durch diese Strukturierung oder Öffnungen 7.1 bzw. 8.1 entsprechend der unterbrochenen Linie 10 der Figur 2 eine innere Kühlerstruktur mit einem sich ständig in allen drei Raumachsen verzweigenden Strömungsweg für:das den Kühler 2 durchströmende Kühlmediums ergibt. Weiterhin ist die Strukturierung so getroffen, dass die aufeinander liegenden und flächig miteinander verbundenen Schichten 7 und 8 durchgehende Pfosten 11 bilden, die bis an die äußeren Schichten 9 reichen und auch mit diesen verbunden sind. Durch die Pfosten 11 ergibt sich eine erhöhte Stabilität für den jeweiligen Kühler 2, insbesondere auch gegen ein Aufblähen beim Durchströmen des Kühlers 2 mit einem mit Druck beaufschlagten Kühlmedium. Weiterhin dienen die Pfosten 11 als Wärmeleiter zum Ableiten der Wärme von der den jeweiligen Schaltkreis 6 aufweisenden Oberseite des Kühlers 2 auch in solche Bereiche der inneren Kühlerstruktur 10, die dieser Oberseite entfernt liegen, wodurch der Wirkungsgrad des jeweiligen Kühlers 2 wesentlich verbessert wird. Weiterhin wird durch die von dem Kühlmediums umströmten Pfosten 11 auch die effektive innere Kühlfläche wesentlich vergrößert.

Durch die beschriebene Ausbildung der Kühler 2 ergibt sich eine von der inneren Kühlerstruktur 10 gebildete innere Kühlfläche die wesentlich größer ist als diejenige Fläche, die von dem jeweiligen Schaltkreis 6 an der Außen- oder Oberfläche des jeweiligen Kühlers eingenommen wird. Die innere Kühlfläche ist wenigstens um den Faktor 3 größer als die Außenfläche, die der Kühler 2 an seiner Ober- oder Unterseite aufweist, auf jeden Fall mindestens um den Faktor 3 größer als die von dem Schaltkreis 6 eingenommene Kühleraußenfläche.

Die Ober- und Unterseite jedes Kühlers 2 ist jeweils von einer Schicht 9 gebildet, die die innere Kühlerstruktur 10 an der betreffenden Seite des Kühlers 2 nach außen hin dicht verschließt. Es versteht sich, dass die Strukturierung der Schichten 7 und 8 so ausgeführt ist, dass sich der von den Öffnungen 7.1 und 8.1 gebildete siebartige Bereich von einem geschlossenen Rand umgeben ist, sodass der von den Öffnungen 7.1 und 8.1 gebildete strukturierte und von dem Kühlmedium durchströmte Bereich 10 auch am Umfang jedes Kühlers 2 verschlossen ist.

Bei der dargestellten Ausführungsform weisen die Schichten 7-9 jeweils einen rechteckförmigen Zuschnitt auf, sodass auch die Kühler 2 in Draufsicht rechteckförmig ausgebildet sind. Im Bereich der beiden Schmalseiten ist jeder Kühler 2 mit jeweils einer durchgehenden Bohrung 12 bzw. 13 versehen, die von der Oberseite bis an die Unterseite des jeweiligen Kühlers 2 reicht und zum Zuführen des Kühlmediums (Bohrung 12) sowie zum Abführen des Kühlmediums (Bohrung 13) dienen. Die Bohrungen 12 und 13, die beispielsweise durch entsprechende Strukturierung der Schichten 7-9 oder aber durch Bearbeitung des Kühlers 2 nach dem Verbinden der Schichten 7-9 erzeugt sind, münden jeweils auch in den strukturierten Bereich 10.

Wie die Figur 1 zeigt, sind die einzelnen Kühler 2 jeweils durch Abstandhalter 14 voneinander beabstandet, die an den Schmalseiten der Kühler 2 vorgesehen sind. Die Abstandhalter 14 sind entsprechend der Figur 3 quaderförmig ausgeführt und liegen mit ihrer Längserstreckung parallel zu und auch bündig mit der betreffenden Schmalseite, jeder Abstandhalter besitzt eine Bohrung 15, die im montierten Zustand des Moduls 1 deckungsgleich mit einer Bohrung 12 bzw. 13 ist, sodass sich die Bohrungen 15 und 12 bzw. 15 und 13 jeweils zu einem Kanal zum Zuführen bzw. zum Abführen des Kühlmediums ergänzen. An dem in der Figur 1 unteren Kühlern 2 sind an der Unterseite und im Bereich jeder Schmalseite ein Abschtussstück 16 vorgesehen, welches hinsichtlich seiner Ausbildung und Formgebung beispielsweise einem Abstandhalter 14 ohne Bohrung 15 entspricht, vorzugsweise aber eine gegenüber den Abstandhaltern 14 reduzierte Dicke aufweist.

Um den aus den Kühlern 2, den Abstandhaltern 14 und den Abschlussstücken 16 bestehenden Aufbau zusammenzuhalten sind bei der dargestellten Ausführungsform eine obere sowie eine untere Halte- oder Spannplatte 17 bzw 18 vorgesehen, die mit ihren Oberflächenseiten jeweils parallel zu den Oberflächenseite der Kühler 2 orientiert sind.

Die obere Spannplatte 17 ist über zwei Abstandhalter 14 von dem benachbarten oberen Kühler 2 beabstandet. Die untere Halteplatte 18 liegt mit einer den Kühler 2 zugewandten Oberflächenseite gegen die beiden Abschlussstücke 16 an. Durch mehrere, nicht dargestellte Spannschrauben oder -bolzen, die durch sich deckende Öffnungen 19 in den Kühlern 2, den Abstandhaltern 14, den Abschlusstücken 16 und den Spannptatten 17 und 18 vorgesehen, sind, sind die das Modul 1 bildenden Elemente miteinander verspannt, wie dies mit der unterbrochenen Linie 20 angedeutet ist. In der oberen Spannplatte 17 sind weiterhin Öffnungen 21 vorgesehen, durch die Anschlussrohre oder Anschlussstutzen 22 nach außen geführt sind, über die dann das Modul 1 mit nicht dargestellten Leitungen zum Zuführen und Abführen des Kühlmediums verbunden werden kann. Die bei der dargestellten Ausführungsform rohrartig ausgebildeten Anschlussstutzen 22 sind jeweils mit einem Ende in einer Bohrung 15 der zwischen der Spannplatte 17 und dem benachbarten Kühler 2 vorgesehenen Abstandhalter 14 gehalten, und zwar beispielsweise durch Einschrauben in ein Innengewinde der entsprechenden Bohrung 15.

Für einen dichten Übergang zwischen den Kühlern 2 und den Abstandhaltern 14 sowie den Abschlussstücken 16 sind Dichtungen, z.B. Ringdichtungen 23 vorgesehen. Um diese Dichtungen eindeutig zu positionieren, sind die Abstandhalter 14 beispielsweise jeweils mit Öffnungen der Bohrungen 15 umschließende Vertiefungen zur teilweisen Aufnahme je einer Dichtung 23 versehen. Auch die Abschlussstücke 16 besitzen entsprechende Vertiefungen. Die Abstandhalter 14 sowie die Abschlussstücke 15 sind beispielsweise aus einem elektrisch isolierenden Material hergestellt, beispielsweise als Form- oder Spritzgießteile aus Kunststoff.

Die Dicke der Abstandhalter 14 und damit der Abstand zwischen den einander benachbarten Kühlern 2 ist so gewählt, dass sich einerseits eine kompakte Bauform für das Modul 1 ergibt, andererseits der Zwischenraum 24 zwischen zwei Kühlern 2 bzw. zwischen der oberen Spannplatte 17 und dem benachbarten Kühler 2 ausreichend Platz für den jeweiligen Schaltkreis 6 sicher stellt, der zwischen den beiden Schmalseiten des Kühlers 2 und damit zwischen den beiden Abstandhaltern 14 am Kühler vorgesehen ist. Die Anschlüsse 25 (Spannungsanschlüsse, Steueranschlüsse usw.) sind bei der dargestellten Ausführungsform jeweils an den Längsseiten der Kühler 2 und damit an den Längsseiten des Moduls 1 nach außen geführt, wie dies in der Figur 2 dargestellt ist. Hierdurch ist eine besonders einfache Verbindung mit äußeren Anschlusselementen oder Leitungen möglich. Bevorzugt sind die Anschlüsse 25 dann in einem vorgegebenen Raster vorgesehen, um so das gesamte Modul 1 und dessen Anschlüsse 25 durch Anstecken an äußeren Mehrfach-Anschlussleisten anschließen zu können.

Wie die Figur 7 zeigt, sind die Schaltkreise 6 jeweils unter Verwendung eines Substrates 26 hergestellt, welches u. a. eine isolierschicht, d. h. bei der dargestellten Ausführungsform eine Keramikschicht 27 aufweist, die an ihren beiden Oberflächenseiten metallisiert ist, d. h. bei der dargestellten Ausführungsform mit einer Kupferschicht 28 bzw. 29 versehen ist. Von diesen Kupferschichten, die beispielsweise mit dem bekannten DCB-Verfahren (Direct Copper Bonding) auf der Keramikschicht 27 (z. B. Al₂O₃-Keramik) vorgesehen sind, ist die Kupferschicht 28 zur Bildung von Leiterbahnen, Anschlüssen und Kontakt- oder Montageflächen für die Bauelemente 3-5 usw. entsprechend strukturiert. Die Kupferschicht 29 ist in geeigneter Weise flächig mit der Oberseite des jeweiligen Kühlers 2 verbunden, beispielsweise durch Kleben unter Verwendung eines wärmeleitenden Klebers durch Löten (auch Aktiv-Löten) oder aber durch Direct-Bonden bzw. DCB-Bonden oder Aktivlöten, wobei bei der Herstellung des jeweiligen Substrates 26 durch Direct-Bonden (DCB-Verfahren) dieses Substrat bereits bei der Herstellung des Kühleres mit gefertigt werden.

Für die Herstellung der mit den Schaltkreisen 6 versehenen Kühler bestehen somit u. a. zwei grundsätzliche Möglichkeiten, und zwar in der Form, dass in gesonderten Prozessen die Schaltkreise 6 und die Kühler 2 gefertigt und erst dann verbunden werden, und zwar die Schaltkreise 6 dadurch, dass zunächst die Substrate 26 gefertigt, an der Kupferschicht 26 strukturiert, dann mit den Bauelementen 3-5 bestückt und schließlich zur Bildung des jeweiligen Gehäuses 6.1 mit Kunststoff vergossen werden. Die so fertig gestellten Substrate 6 werden dann auf dem jeweiligen vorgefertigten Kühler 2 montiert. Diese Herstellungsmethode hat den Vorteil, dass die Herstellung der Substrate 26, deren Strukturierung und Bestückung im Mehrfachnutzen erfolgen kann.

Die anderen grundsätzliche Möglichkeit einer Fertigung besteht darin, dass zusammen mit dem jeweiligen Kühler 2 auch das zugehörige Substrat 26 gefertigt und dann die Kupferschicht 28 zur Bindung von Leiterbahnen, Kontaktflächen usw. strukturiert wird. Anschließend erfolgt das Bestücken mit den Bauelementen 3-5 und das Umspritzen mit Kunststoff zur Bildung des jeweiligen Gehäuses 6.1.

Allen Verfahren ist gemeinsam, dass erst die mit den Schaltkreisen 6 versehenen Kühler 2 zu dem Modul 1 zusammengefügt werden, sodass der angestrebte kompakte Aufbau bei vereinfachter Fertigung möglich ist.

Die Figur 7 zeigt in einer Darstellung ähnlich Figur 6 den Schichtaufbau im Bereich eines Schaltkreises 6. Das für diesen Aufbau verwendete Substrat 26a unterscheidet sich von dem Substrat 26 dadurch, dass die Keramik-Schicht 27 unmittelbar auf die Oberseite des betreffenden Kühlers 2 aufgebracht ist, und zwar mit einer geeigneten Verbindungstechnik, wie z. B. Direct-Bonden oder Aktivlöten.

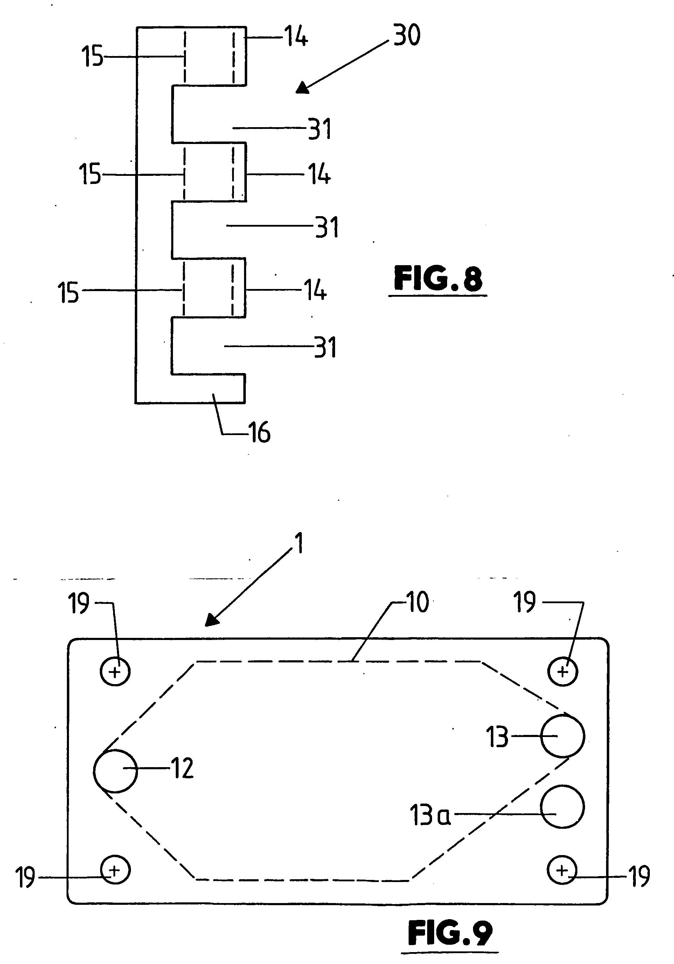

Die Figur 8 zeigt in vereinfachter Darstellung ein Abstandhalter- und Anschlusselement 30, welches beispielsweise als Formteil aus Kunststoff derart hergestellt ist, dass es mit seiner kammartigen Struktur die Abstandhalter 15 sowie das Abschlussstück 16 für jeweils eine Schmalseite des Moduls 1 bildet. Durch die Zusammenfassung der Abstandhalter 14 und des Abschlussstückes 16 zu einem einzigen Bauteil wird die Montage des Moduls wesentlich vereinfacht, d.h. die mit den Schaltkreisen 6 versehenen Kühler 2 werden nach dem Einbringen der Dichtungsringe 23 jeweils in die von der kammartigen Struktur gebildeten Ausnehmungen 31 eingeschoben und dann über die Spannbolzen 20 miteinander sowie auch mit den Halte- und Spannplatten 17 und 18 verspannt.

Wie in der Figur 1 dargestellt, wird das Kühlmedium über die Anschlussstutzen 22 jeweils an der Oberseite des Moduls, d. h. an der oberen Spannplatte 17 zugeführt und auch abgeführt. Um hierbei eine möglichst gleichmäßige Verteilung des Kühlmediums auf sämtliche Kühler 2 und damit eine gleichmäßige Kühlung der Schaltkreise 6 zu erreichen, ist die Strukturierung 10 jedes Kühlers 2 im Bereich zumindest der Öffnung 12, bevorzugt aber auch im Bereich der Öffnung 13 so ausgeführt, dass der effektive Strömungsquerschnitt am Übergang zwischen der Bohrung 12 bzw. 13 und dem strukturierten Bereich 10 kleiner ist als der Querschnitt dieser Bohrungen bzw. der von den Bohrungen 12, 13 und 15 gebildeten Kanäle.

Um die Gleichmäßigkeit der Durchströmung sämtlicher Kühler 2 zu verbessern, kann es zwecksmäßig sein, einen Anschlussstutzen 22 beispielsweise zum Zuführen des Kühlmediums an der Oberseite des Moduls und den anderen Anschlussstutzen 22, beispielsweise zum Abführen des Kühlmediums an der Unterseite des Moduls, d. h. im Bereich der dortigen Spannplatte 18 vorzusehen, um so eine diagonale Durchströmung des Moduls 1 zu erreichen.

Wie in der Figur 9 angedeutet, besteht weiterhin auch die Möglichkeit zusätzlich zu einem der unter Verwendung der Bohrungen 12 oder 13 und 15 erzeugten Kanäle einen weiteren Kanal auszubilden. Dieser weitere Kanal wird von einer zusätzlichen Bohrung 13a in den Kühleren 2 und sich deckenden zusätzlichen Bohrungen in den Abstandhaltern 14 an der betreffenden Schmalseite des Moduls 1 gebildet. Weiterhin ist an dieser Seite des Moduls 1 das untere Abschlussstück 16 so ausgeführt, dass es dort die Bohrung 13 mit der Bohrung 13a verbindet und der obere Abstandhalter 14 ist an dieser Schmalseite so ausgeführt, dass er die Bohrung 13 verschließt. Die Bohrungen 13a befinden sich dabei außerhalb des strukturierten Bereichs 10 der Kühler 2. Durch den von den Bohrungen 13a und den zugehörigen Bohrungen in den Abstandhaltern 14 gebildeten zusätzlichen Kanal ergibt sich trotz der für die gleichmäßige Verteilung des Kühlmediums optimalen diagonalen Durchströmung der Kühleranordnung die Möglichkeit, die Anschlüsse zum Zuführen und Abführen des Kühlmediums an einer gemeinsamen Seite, nämlich z.B. an der Oberseite des Moduls vorzusehen.

Die einzelnen Kühler 2 sind bevorzugt so ausgebildet, dass sie eine Kühlleistung von wenigstens 25 W/cm² aufweisen, und zwar bezogen auf diejenige Fläche, die von dem jeweiligen Substrat 6 eingenommen wird, d. h. mit den Kühlern 2 sind dann Bauelemente oder Schaltkreise 6 kühlbar, die an ihrer mit dem Kühler 2 verbundenen Fläche eine Verlustleistung von wenigstens 25 W/cm² abgeben.

Die Erfindung wurde voranstehend an Ausführungsbeispielen beschrieben. Es versteht sich, dass zahlreiche Änderungen sowie Abwandlungen möglich sind, ohne das dadurch der der Erfindung zugrunde liegende Erfindungsgedanke verlassen wird. So ist es beispielsweise möglich, einen oder mehrere Kühler 2 auch an ihrer der Spannplatte 17 abgewandten Unterseite mit einem oder mehreren Schaltkreisen 6 zu versehen.

### Bezugszeichenliste

- 1: Modul
- 2: Kühler
- 3, 4, 5: Bauelemente
- 3.1: Gehäuse
- 6: Schaltkreis
- 7, 8, 9: Schicht
- 7.1, 8.1: Öffnung
- 10: Strukturierung
- 11: Pfosten
- 12, 13, 13a: Bohrung
- 14: Abstandhalter
- 15: Bohrung
- 16: Abschlussstück
- 17, 18: Halte- oder Spannplatte
- 19: Öffnung
- 20: Spannbolzen
- 21: Öffnung
- 22: Anschlussstück
- 23: Dichtungsring
- 24: Zwischenraum
- 25: Anschluss
- 26, 26a: Substrat
- 27: Keramikschicht
- 28, 29: Kupferschicht
- 30: Abstandhalter- und Anschlusselement
- 31: Zwischenraum

## Patentansprüche

1. Elektrisches Modul mit mehreren an einer gemeinsamen, von einem Kühlmedium durchströmten Kühlerstruktur vorgesehenen elektrischen Bauelementen (3, 4, 5, 6),
mit wenigstens zwei die Kühlerstruktur bildenden plattenförmigen und von dem Kühlmedium durchströmten Kühlern (2), die durch zwischen den Kühlern vorgesehene Abstandhalter parallel zu einander und im Abstand voneinander angeordnet sind,
mit wenigstens einem ersten Kanal (12, 15) zum Zuführen und Verteilen des Kühlmediums an die Kühler (2),
mit wenigstens einem zweiten Kanal (13, 13a, 15) zum Abführen des Kühlmediums von den Kühlern (2),
wobei die Bauelementen (3, 4, 5, 6) jeweils auf einem Kühler (2) gehalten in einem Raum (24) zwischen zwei benachbarten Kühlern (2) vorgesehen ist, ,
**dadurch gekennzeichnet,**
**dass** jeder Kühler (2) aus mehreren miteinander verbundenen Lagen (7, 8, 9) aus einer dünnen Metallfolie besteht
**dass** innere Lagen (7, 8) jedes Kühlers (2) durch in diese Lagen eingebrachte Öffnungen (7.1, 8.1) derart strukturiert sind, dass sich ein innerer, strukturierter Kühlbereich (10) ergibt, der einen sich in allen drei Raumachsen ständig verzweigenden Strömungsweg für das Kühlmedium bildet,
**dass** die miteinander verbundenen Lagen (7, 8) im strukturierten Bereich (10) durchgehende Pfosten (11) bilden, die sich bis an die
die Ober- und Unterseite des betreffenden Kühlers (2) bildenden Lagen (9) erstrecken, und
**dass** die Bauelemente (3, 4, 5, 6) Bestandteil jeweils eines elektrischen Schaltkreises (6) sind, der aus einem mit einem Kühler (2) verbunden Substrat (26, 26a) aus einer Isolierschicht (27) mit wenigstens einseitiger strukturierte Metallisierung (28) besteht, die die Bauelemente (3, 4, 5, 6) trägt.

2. Modul nach Anspruch 1, **dadurch gekennzeichnet, dass** die Anzahl der parallel zueinander und im Abstand voneinander angeordneten Kühler größer als Zwei ist.

3. Modul nach Anspruch 1 oder 2, **dadurch gekennzeichnet, dass** zumindest ein Kühler (2) der Kühleranordnung an zwei einander gegenüberliegenden Seiten jeweils wenigstens ein zu kühlendes Bauelement (3, 4, 5) aufweist, und dass die Bauelemente (3, 4, 5) jeweils Bestandteil des elektrischen Schaltkreises (6) mit dem Substrat (26, 26a) sind.

4. Modul nach einem der vorhergehenden Ansprüche, **dadurch gekennzeichnet dass** die Dicke der Kühler (2) um ein Vielfaches kleiner ist als deren Abmessung in Draufsicht, beispielsweise Breite und/oder Länge,
und/oder
dass die Kühler (2) parallel zueinander in einem Kühlmediumkreislauf angeordnet sind.

5. Modul nach einem der vorhergehenden Ansprüche, **gekennzeichnet durch** wenigstens einen ersten Kanal (12, 15) zum Zuführen und Verteilen des Kühlmediums an die Kühler (2) sowie **durch** wenigstens einen zweiten Kanal (13, 13a, 15) zum Abführen des Kühlmediums von den Kühlern (2), wobei der wenigstens eine erste Kanal (12, 15) und/oder der wenigstens eine zweite Kanal (13, 15) z.B. teilweise in den Abstandhaltern ausgebildet sind..

6. Modul nach einem der vorhergehenden Ansprüche, **gekennzeichnet durch** Anschlüsse (22) zum Anschließen des Moduls an einen Kühlmediumkreislauf, und dass die Anschlüsse (22) an einer gemeinsamen Seite des Moduls (1) vorgesehen sind..

7. Modul nach einem der vorhergehenden Ansprüche, **dadurch gekennzeichnet, dass** die Kühler (2) durch Abstandhalter (14) und/oder Abschlussstücke (16) voneinander und/oder von das Modul (1) zusammenhaltenden Spannelementen, beispielsweise Spannplatten (17, 18) beabstandet sind, wobei die Abstandhalter (14) oder Abschlussstücke (16) beispielsweise aus einem elektrisch isolierenden Material, z.B. aus Kunststoff gefertigt und/oder quader- oder plattenförmig ausgeführt sind.

8. Modul nach einem der vorhergehenden Ansprüche, **dadurch gekennzeichnet dass** an zwei einander gegenüberliegenden Seiten des Moduls (1) jeweils mehrere Abstandhalter (14) vorgesehen sind, und dass die Abstandhalter an jeder Seite des Moduls von wenigstens einem Abstandhalterelement (30) gebildet sind.

9. Modul nach Anspruch 8, **dadurch gekennzeichnet, dass** die Abstandhalter (14) und/oder Abschlussstücke (16) von einem gemeinsamen Abstandhalterelement (30) gebildet sind.

10. Modul nach einem der vorhergehenden Ansprüche, **dadurch gekennzeichnet, dass** das wenigstens eine Bauelement (3, 4, 5) und/oder der wenigstens eine Schaltkreis (6) zwischen dem wenigstens einen ersten Kanal und dem wenigstens einen zweiten Kanal (13, 13a, 15) oder zwischen zwei Abstandhaltern (14) vorgesehen ist.

11. Modul nach einem der vorhergehenden Ansprüche, **dadurch gekennzeichnet, dass** elektrische Anschlusselemente (25) zum Anschließen des Moduls (1) an äußere Verbindungen an wenigstens einer gemeinsamen Seite des Moduls vorgesehen sind.

12. Modul nach einem der vorhergehenden Ansprüche, **dadurch gekennzeichnet, dass** die Kühler (2) jeweils eine innere, mit dem Kühlmedium unmittelbar in Berührung stehende Kühlfläche sowie eine äußere, mit dem wenigstens einem Bauelement oder dem wenigstens einen Schaltkreis (6) in Verbindung stehende Kühlfläche bilden, und dass die innere Kühlfläche größer ist als die äußere Kühlfläche, beispielsweise wenigstens um den Faktor Drei größer ist als die äußere Kühlfläche,
und/oder
dass jeder Kühler eine Kühlleistung von wenigstens 25 W/cm² aufweist, und zwar bezogen auf die von dem wenigstens einen zu kühlenden Bauelement (3, 4, 5) oder dem wenigstens einen zu kühlenden Substrat (6) eingenommene Kühleraußenfläche.

13. Modul nach einem der vorhergehenden Ansprüche, **dadurch gekennzeichnet, dass** das Substrat (26) beispielsweise auch an der anderen Oberflächenseite der Isolierschicht (27) mit einer Metallisierung (29) versehen ist, die ihrerseits mit dem Kühler (2) verbunden ist und/oder unter Anwendung des Direct-Bonding-Verfahrens (DCB-Verfahren) oder unter Verwendung des Aktivlöt-Verfahrens hergestellt und/oder mit dem jeweiligen Kühler (2) verbunden ist.

## Claims

1. Electrical module having several electrical components (3, 4, 5, 6) provided on a common cooler structure through which a cooling medium passes,
with at least two plate-type coolers (2) which make up the cooler structure and through which the cooling medium passes and which are arranged parallel to one another and spaced from one another by spacers provided between the coolers,
with at least a first channel (12, 15) for supplying and distributing the cooling medium to the coolers (2),
with at least a second channel (13, 13a, 15) for draining the cooling medium from the coolers (2), wherein the components (3, 4, 5, 6) are each provided on one cooler (2) held in a space (24) between two adjoining coolers (2)
**characterised in that** each cooler (2) consists of several interconnected layers (7, 8, 9) of a thin metal foil,
that the inner layers (7, 8) of each cooler (2) are structured by apertures (7.1, 8.1) formed in these layers in such a way that an inner structured cooling area (10) is produced which forms a flow path for the cooling medium which branches out continuously in all three spatial axes,
that the interconnected layers (7, 8) in the structured area (10) form full-length posts (11) which extend up to the layers (9) forming the top and bottom sides of the relevant cooler (2), and
that the components (3, 4, 5, 6) are each a constituent part of one electrical circuit (6) which consists of a substrate (26, 26a) connected to a cooler (2) and consisting of an insulation layer (27) having a structured metal plating ((28) on at least one side which supports the components (3, 4, 5, 6).

2. Module according to claim 1 **characterised in that** the number of coolers arranged parallel to one another spaced from one another is greater than two.

3. Module according to claim 1 or 2 **characterised in that** at least one cooler (2) of the cooler assembly has on each of the two opposite sides at least one component (3, 4, 5) which is to be cooled, and that the components (3, 4, 5) are each a constituent part of the electrical circuit (6) with the substrate (26, 26a).

4. Module according to one of the preceding claims, **characterised in that** the thickness of the cooler (2) is smaller by a multiple than its dimensions in plan view, by way of example width and/or length,
and/or that the coolers (2) are arranged parallel to one another in a cooling medium circuit,

5. Module according to one of the preceding claims, **characterised by** at least a first channel (12, 15) for supplying and distributing the cooling medium to the coolers (2) as well as by at least a second channel (13, 13a, 15) for draining the cooling medium from the coolers (2) wherein the at least one first channel (12, 15) and/or the at least one second channel (13, 15) are formed for example in part in the spacers.

6. Module according to one of the preceding claims **characterised by** connectors (22) for connecting the module to a cooling medium circuit, and that the connectors (22) are provided on a common side of the module (1).

7. Module according to one of the preceding claims **characterised in that** the coolers (2) are spaced by spacers (14) and/or closure members (16) from one another and/or from tension elements, by way of example tension plates (17, 18), which hold the module (1) together, wherein the spacers (14) or closure members (16) are made by way of example from an electrically insulating material, e.g. from plastics and/or are designed block- or plate-shaped.

8. Module according to one of the preceding claims **characterised in that** several spacers (14) are provided on each of two opposing sides of the module (1), and that the spacers are formed on each side of the module by at least one spacer element (30).

9. Module according to claim 8 **characterised in that** the spacers (14) and/or closure members (16) are formed by a common spacer element (30).

10. Module according to one of the preceding claims **characterised in that** the at least one component (3, 4, 5) and/or the at least one circuit (6) is provided between the at least one first channel and the at least one second channel (13, 13a, 15) or between two spacers (14).

11. Module according to one of the preceding claims **characterised in that** electrical connector elements (25) are provided on at least one common side of the module for attaching the module (1) to exterior connections.

12. Module according to one of the preceding claims **characterised in that** the coolers (2) each form an interior cooling surface set in direct contact with the cooling medium, as well as an exterior cooling surface which is in connection with at least one component or the at least one circuit (6), and that the interior cooling surface is greater than the exterior cooling surface, by way of example by at least the factor of three greater than the exterior cooling surface,
and/or that each cooler has a cooling capacity of at least 25 W/cm², namely in relation to the exterior surface of the cooler occupied by the at least one component (3, 4, 5) which is to be cooled or the at least one substrate (6) which is to be cooled.

13. Module according to one of the preceding claims **characterised in that** the substrate (26) is provided by way of example also on the other surface side of the insulating layer (27) with a metal plating (29) which is connected in turn to the cooler (2) and/or is produced by applying the direct bonding process (DCB process) or by using the active soldering process and/or is connected to each relevant cooler (2).

## Revendications

1. Module électrique comprenant plusieurs composants électriques (3, 4, 5, 6) aménagés sur une structure de refroidissement commune parcourue par un agent réfrigérant,
au moins deux organes de refroidissement (2) en forme de plaques formant la structure de refroidissement et parcourus par l'agent réfrigérant, lesquels organes de refroidissement sont aménagés parallèlement l'un à l'autre et à distance l'un de l'autre par des espaceurs disposés entre les organes de refroidissement,
au moins un premier canal (12, 15) pour acheminer et distribuer l'agent réfrigérant sur les organes de refroidissement (2),
au moins un second canal (13, 13a, 15) pour évacuer l'agent réfrigérant des organes de refroidissement (2),
dans lequel les composants (3, 4, 5, 6) sont maintenus respectivement sur un organe de refroidissement (2) dans un espace (24) entre deux organes de refroidissement voisins (2),
**caractérisé en ce que**
chaque organe de refroidissement (2) est constitué de plusieurs couches (7, 8, 9) reliées l'une à l'autre et formées d'une feuille métallique mince, les couches internes (7, 8) de chaque organe de
refroidissement (2) sont structurées par des ouvertures (7.1, 8.1) ménagées dans ces couches de sorte que l'on obtienne une zone de refroidissement interne structurée (10) qui forme pour l'agent réfrigérant une voie d'écoulement qui se ramifie en permanence dans la totalité des trois dimensions,
les couches (7, 8) reliées l'une à l'autre de la zone structurée (10) forment des montants ininterrompus (11) qui s'étendent jusqu'aux couches (9) formant la face supérieure et la face inférieure de l'organe de refroidissement (2) concerné, et
les composants (3, 4, 5, 6) font partie respectivement d'un circuit de commutation électrique (6) qui est constitué d'un substrat (26, 26a) connecté à un organe de refroidissement (2), lequel substrat est formé d'une couche isolante (27) avec une métallisation (28) structurée au moins d'un côté et qui supporte les composants (3, 4, 5, 6).

2. Module selon la revendication 1, **caractérisé en ce que** le nombre des organes de refroidissement aménagés parallèlement l'un à l'autre et à distance l'un de l'autre est supérieur à deux.

3. Module selon la revendication 1 ou 2, **caractérisé en ce qu'**au moins un organe de refroidissement (2) de l'aménagement de refroidissement présente, sur deux côtés en regard l'un de l'autre, respectivement au moins un composant à refroidir (3, 4, 5) et les composants (3, 4, 5) font respectivement partie du circuit de commutation électrique (6) avec le substrat (26, 26a).

4. Module selon l'une quelconque des revendications précédentes, **caractérisé en ce que** l'épaisseur des organes de refroidissement (2) est plus petite d'un multiple que leur dimension en vue de dessus, en particulier la largeur et/ou la longueur,
et/ou
les organes de refroidissement (2) sont aménagés parallèlement l'un à l'autre dans un circuit d'agent réfrigérant.

5. Module selon l'une quelconque des revendications précédentes, **caractérisé par** au moins un premier canal (12, 15) pour acheminer et distribuer l'agent réfrigérant sur les organes de refroidissement (2) ainsi que par au moins un deuxième canal (13, 13a, 15) pour évacuer l'agent réfrigérant des organes de refroidissement (2), dans lequel le au moins un premier canal (12, 15) et/ou le au moins un deuxième canal (13, 15) et ou sont formés, par exemple, en partie dans les espaceurs.

6. Module selon l'une quelconque des revendications précédentes, **caractérisé par** des raccords (22) pour raccorder le module à un circuit de réfrigérant et en ce que les raccords (22) sont aménagés sur un côté commun du module (1).

7. Module selon l'une quelconque des revendications précédentes, **caractérisé en ce que** les organes de refroidissement (2) sont espacés l'un de l'autre par des espaceurs (14) et/ou des pièces de fermeture et/ou par des éléments de serrage confinant le module (1), par exemple des plaques de serrage (17, 18), dans lequel les espaceurs (14) ou les pièces de fermeture (16) sont fabriqués en matériau isolant de l'électricité, par exemple en matière synthétique, et/ou se présentent sous la forme de carreaux ou de plaques.

8. Module selon l'une quelconque des revendications précédentes, **caractérisé en ce qu'**il est prévu sur deux côtés du module en regard l'un de l'autre respectivement plusieurs espaceurs (14) et **en ce que** les espaceurs sont formés, sur chaque côté du module, par au moins un élément d'espacement (30).

9. Module selon la revendication 8, **caractérisé en ce que** les espaceurs (14) et/ou les pièces de fermeture (16) sont formés par un élément d'espacement commun (30).

10. Module selon l'une quelconque des revendications précédentes, **caractérisé en ce que** le au moins un composant (3, 4, 5) et/ou le au moins un circuit de commutation (6) est ou sont prévus entre le au moins un premier canal et le au moins un deuxième canal (13, 13a, 15) ou entre deux espaceurs (14).

11. Module selon l'une quelconque des revendications précédentes, **caractérisé en ce qu'**il est prévu des éléments de connexion électrique (25) pour connecter le module (1) à des connexions externes sur au moins un côté commun du module.

12. Module selon l'une quelconque des revendications précédentes, **caractérisé en ce que** les organes de refroidissement (2) forment respectivement une surface de refroidissement interne directement en contact avec l'agent réfrigérant ainsi qu'une surface de refroidissement externe connectée à au moins un composant ou à au moins un circuit de commutation (6) et **en ce que** la surface de refroidissement externe est plus grande que la surface de refroidissement externe, par exemple plus grande au moins du facteur trois que la surface externe,
et/ou
**en ce que** chaque organe de refroidissement présente une puissance de refroidissement d'au moins 25 W/cm² et ce, par rapport à la surface externe de refroidissement occupée par le au moins un composant (3, 4, 5) à refroidir ou par le au moins un substrat à refroidir (6).

13. Module selon l'une quelconque des revendications précédentes, **caractérisé en ce que** le substrat (26) est pourvu, par exemple également sur l'autre surface de la couche isolante (27), d'une métallisation (29) qui est connectée pour sa part à l'organe de refroidissement (2) et/ou est fabriquée par application du procédé de liaison directe (procédé DCB) ou par application du procédé de soudage actif et/ou est connectée à l'organe de refroidissement respectif (2).
